# EUROPEAN PATENT SPECIFICATION

(11) **EP 0 434 293 B1**
(45) Date of publication and mention of the grant of the patent: **27.03.1996**
(21) Application number: 90313521.8
(22) Date of filing: 12.12.1990
(51) Int. Cl.: H03D 3/04, G01R 23/10

(54) **Method and device for the detection of an FM or PM modulated signal**
Verfahren und Einrichtung zum Detektieren von FM oder PM modulierter Signale
Procédé et dispositif pour la détection d'un signal modulé en fréquence ou en phase

(30) Priority: 22.12.1989 FI 896267
(43) Date of publication of application: 26.06.1991
(73) Proprietor: NOKIA MOBILE PHONES LTD., SF-24101 Salo (FI)
(72) Inventor: Rapeli, Juha, SF-90570 Oulu (FI); Rahkonen, Timo, SF-90560 Oulu (FI); Kostamovaara, Juha, SF-90570 Oulu (FI)
(74) Representative: Crawford, Andrew Birkby

(56) References cited:
- FR-A- 2 550 671
- GB-A- 2 204 201

## Description

The object of the invention is a method based on direct time interval measurement for the detection of an FM or PM modulated signal and a device for that purpose.

It is known to demodulate a phase or frequency modulated transmission in various ways. A phase or frequency modulated transmission is often detected with a phase lock comprising a phase discriminator, a loop filter and a controlled oscillator, which interlocks on the same frequency with the input signal. Thereby the controlling signal for the oscillator is used as the detected signal. It is possible to realize the phase lock as an analog or a digital phase lock. The characteristics of an analog phase lock are Influenced i.a. by the control range of the voltage controlled oscillator and linearity and by the output noise of the loop filter. A controlled oscillator in a digital phase lock is more easily designed to be linear than an analog oscillator, but a digital phase lock can be locked only to discrete frequencies, whereby the detected signal will include phase noise, the oscillator changing between the two closest frequencies. The digital phase locks operate further on relatively low frequencies.

A phase lock is a non-linear, closed loop system, the behavior of which is difficult to analyze. The optimization of the characteristics is limited by the feedback loop, which has to remain stable. This means that the number of methods for filtering a signal is rather limited. Analog phase locks consume power continuously, and often they use coils, which are inconvenient components regarding the production engineering. Digital filters are often used in modems, whereby the detected signal must be converted into a digital signal with separate analog-to-digital converters.

The commonly used quadrature detector is based on a tuned resonant circuit which is used to cause a frequency dependent phase shift in the signal. Quadrature detectors are also non-linear, causing a difficult design tradeoff between sensitivity and linearity and the active components and the resonant circuits needed for said detectors are expensive and difficult to use due to individual variations and temperature dependence.

It is known to use time interval measurements for the measurement of static or slowly drifting frequencies. In these the frequency or phase is measured using generally a digital frequency counter with an internal reference oscillator and a counter counting the cycles of the reference oscillator during a cycle of the signal to be measured. Because the reference oscillator for practical reasons cannot have a very high frequency, the resolution for a single measurement of the counter principle is poor, and thus it has not been used to measure rapidly changing signals.

One realization of frequency demodulation is presented in US patent 4 567 442. The instantaneous amplitude of the angle modulated signal is sampled with an A/D-converter and digitally delayed samples are selectively summed to get two amplitude values, the ratio of which is proportional to the instantaneous frequency. This method has a disadvantage, that it requires a high-speed and power consuming A/D-converter and arithmetic computations for dividing two numbers.

It is commonly known to use time interval measurements for measuring static or slowly modulated frequencies. In these applications, the frequency is generally measured using a digital frequency counter having an internal reference oscillator and a counter that counts the cycles of the reference oscillator during the time between two (or more) successive zero crossings of the signal to be measured. In a publication IEEE Spectrum, July 1988, pages 28-32 Chu:"Phase Digitizing sharpens Timing Measurements", a method for measuring angle modulation is presented, but it uses such a high clock frequency and consumes so much power that the principle is impractical for hand-held applications. A device based on a similar principle is presented in US pat 3,548,328, which device also needs a very high clock frequency. An advantage of these two devices (and all the following ones) is that only zero-crossing information is used and the demodulated signal is automatically converted to digital, so that no separate A/D converter is needed.

The resolution of time interval measurements can be improved with various interpolation techniques, so that the same resolution can be achieved with lower clock frequency (or without a clock signal at all). One way of increasing the resolution while keeping power consumption very low is to use as an interpolator an integrated, tapped delay line comprising of CMOS logic gates. In US pat. 4,593,266 an integrated, tapped delay line is used for delaying the edge of the signal to be detected, and the next edge. This scheme is however impractical for the following reasons. Firstly, when frequency deviation is small (e.g. +/- 5 kHz in a 455 kHz intermediate frequency (IF) signal in mobile communication systems), a very long delay line is needed. A 1000 taps long delay line, for example, would give only about +/- 10 quantization levels of the modulation, and using present technology, such long delay lines are not linear enough for practical applications without trimming. Secondly, in US-4 593 266, the coincidence logic relies on the idea, that the width of the pulse remains constant in the delay line, which is very difficult to achieve especially if the delays also need to be controllable.

A demodulation method that combines the usage of a tapped delay line and a clock signal is presented in Japanese pat. JP 63-267005, where the FM signal propagates in a delay line comprising CMOS buffers, and the clock signal is used to latch the phase of the signal at every rising clock edge. Two successively latched phase measurements are used to interpolate the time when the signal edge crossed the midpoint of the delay line. Due to the interpolation formulae used, the unit delays in the delay line need not be (and are not) calibrated to any specific value, but also this scheme has some features that make it impractical. First, the total delay of the delay line needs to be at least two clock cycles which makes the delay line unnecessarily large. Secondly, because the measurement range of the interpolator is not fixed, every result must be scaled requiring at least three additions and one division for every detected zero-crossing. These hardware-consuming real-time computations and the large size of the interpolator make this realization impractical.

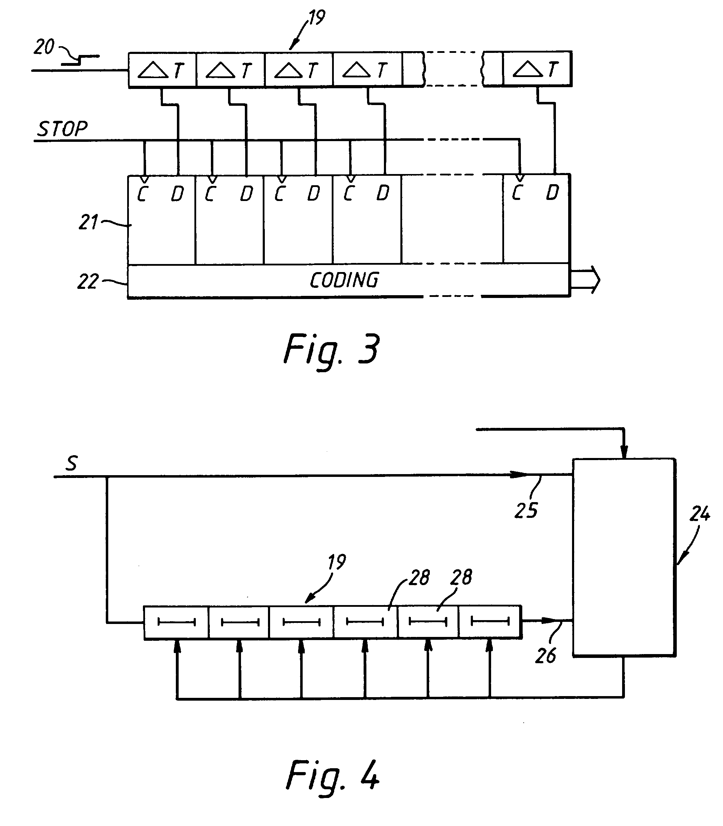

Another combination of a frequency counter and a short (8 taps long) interpolating delay line is presented in British Patent Appl. GB 2,204,201. However, neither realization nor calibration method for the interpolator is given, and the schematics given in fig. 3 in this application suggest, that a startable high-frequency oscillator would be needed, which usually is very difficult to realize. In order to get adequate resolution, the input signal is first rectified to double the deviation of the FM signal and then divided to a much lower frequency, the cycle time of which can be measured. Although dividing input frequency by a factor of M makes the time measurements much easier, a lot of information about the signal is lost (as only every Mth edge is detected), and especially when the signal is noisy, this method has been found to give worse detection than a system where time between each pair of consecutive zero crossings can be measured.

The present invention relates to a method and a device, with which both ac and dc information in a frequency or phase modulated signal can be demodulated digitally using time interval measurements. An FM or PM modulated signal is detected directly without the disadvantages of the analog or digital phase lock. In the method the input signal frequency or phase is measured sufficiently often with respect to the bandwidth of the modulating signal, whereby samples of the modulating signal are obtained, taken directly at the measurement frequency.

The method according to the invention is defined by the features presented in claim 1, and the device is defined by the features presented in claim 8.

In the method the signal is detected so that the instantaneous cycle time of the modulated input frequency is measured by direct time interval measurement using a counter and a delay line. The phase modulation and the instantaneous frequency can be calculated from deviations in the cycle period. Because the method demands from the time measurement a higher resolution than normal frequency counters can achieve with reasonable clock frequencies, the measurement sensitivity is improved in accordance with the invention with a counter and a digital delay line interpolator. The counter is used for rough digitization and the delay line for interpolating the moment of zero-crossing inside the clock cycle. The delay line can be realized in different ways as will be apparent in the subclaims.

The invention is described in more detail below with reference to the enclosed figures clarifying the principle of the invention, in which:
- figure 1: is a block diagram of the device according to the invention;
- figure 2: shows the time measurement based on a reference clock with a combination of a counter and a delay line;
- figure 3: shows the time measurement using a delay line with tapping points;
- figure 4: shows an automatic calibration of the delay line.

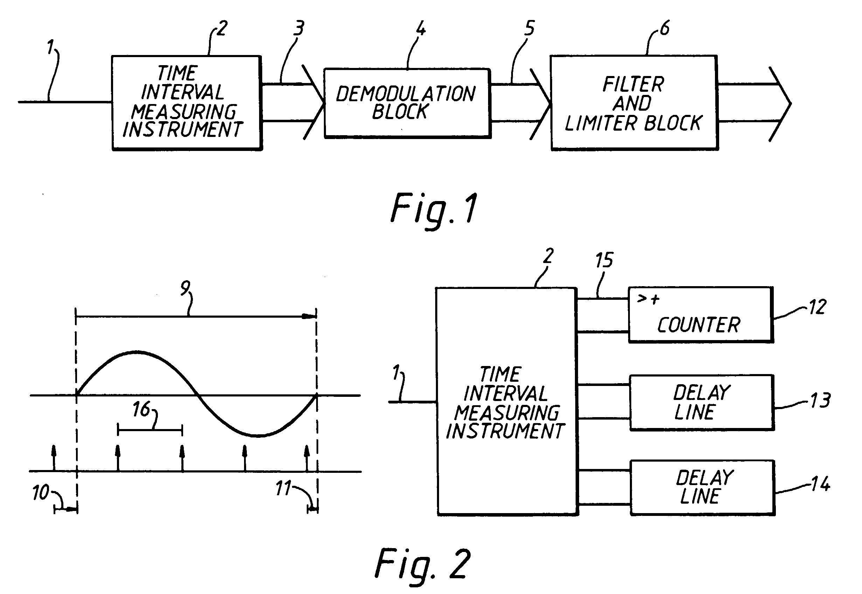

According to figure 1 the detection according to the invention is based on the measurement of the modulated input signal instantaneous cycle time with a direct time interval measurement using a time-to-digital converter. The cycle time 3 of the signal 1 is measured with a time interval measuring instrument 2. The signal is demodulated in the block 4. The instantaneous frequency 5 is obtained as the inverse of the instantaneous cycle time, the phase modulation is detected as instantaneous cycle time changes. The detected signal 5 is directed for further processing in a filter and limiter block 6. The measuring method does not include any feedback loop, whereby the processing of the measurement results can be made more freely than when phase locks are used. The result obtained is also already digital.

The method according to the invention demands a very high resolution from the time measurement.

The cycle period 9 of a signal 1 ie. the time between two rising (or falling) edges of the signal is digitized roughly by a counter 12 so that it counts the number of full cycles of a reference clock 15. The clock pulses are shown as impulses on the left hand side of figure 2. Thereafter, more accurate digitization is accomplished by delay lines 13 and 14, which interpolate fractions 10, 11 of one clock period i.e. they interpolate the moment of zero-crossing of the signal 1 inside the clock cycle. Since the delay elements of the delay lines are controlable, the interpolating range of the delay line (i.e. the longest time interval the interpolator can measure) is fixed to equal one clock cycle 16, whereupon the result of the counter 12 and the result of the delay lines 13 and 14 are able to be combined directly.

In figure 3 there is shown the operating principle in time interval measurements with a delay line 19 composed of delay elements ΔT: at the beginning of the time interval a pulse or its edge 20 is sent into the delay line 19, the edge setting the data inputs D of the flip-flops 21 when it propagates through the delay line 19 consisting of delay elements ΔT. When the time interval is ended , the state of the delay line is stored and the length of the time interval is coded from the position of the last set flip-flop. It is possible to achieve a single measurement resolution less than one nanosecond by using fast logic gates as delay elements.

There are several possibilities for the realization of the delay line. The construction of figure 3 may be used, or the delay elements may themselves be flip-flops, the delay of which is used as the delay unit. The time interval end mark can also have its own delay line, faster than the delay line for the start mark, or the start and end marks can propagate in the same delay line but with different speeds.

The delay of the delay lines is adjustable, whereby it is possible to adjust the total length and the resolution of the delay line to a desired value, which is selected to equal the cycle time of the reference clock. The total delay of the delay line 19 can automatically be calibrated to equal the reference clock cycle with a clock signal S according to Figure 4.

The control circuitry 24 compares signals 25 and 26. The first one 25 is the clock signal S arriving directly to it. The second one 26 is the clock signal S delayed by a delay line 19. The control circuitry 24 adjusts the delay of each particular delay element 28 in such a way that the total delay of the delay line 19 equals one cycle of the clock signal S; i.e. the edges of the signals 25 and 26 arrive at the control circuitry 24 simultaneously.

The measured cycle time or its deviation from the cycle time of the center frequency is converted to an instantaneous frequency or to a frequency deviation e.g. with a correction table. If the frequency deviation Df of the input signal is sufficiently small in comparison to the center frequency fₒ, the frequency deviation can be directly evaluated also as an instantaneous cycle time deviation DT from the cycle time 1/fₒ of the center frequency:
DT = 1/(fₒ + D_{f}) - 1/fₒ, from which Df is solved as:
D_{f} = -DT fₒ ² / (1 + fₒDT)

If the frequency deviation is small enough, use of correction tables and calculation units can be avoided. A small frequency deviation can thus be evaluated directly from the cycle time deviation without using any correction tables or calculation.

It is obvious that the method is applied in such a way that measuring results of the time interval, which exceed a known modulation or which are otherwise unsuitable, can be discarded, limited or replaced with other values, and that said measurement results can be averaged, filtered or otherwise processed so that disturbances in the signal are minimized.

The device according to the invention presents in production engineering terms an easy and little power consuming direct detection, which will not present restrictions on means for the removal of disturbances in the signal. The detected result is already in digital form, so that no separate analog-to-digital converter will be needed.

## Claims

1. A method of demodulating a frequency or phase modulated signal (1) using a time-to digital converter (2) including a counter (12) for counting cycles of a reference clock frequency of the time-to-digital converter and a delay line interpolator (13,19) **characterized in that** it comprises the steps of :
calibrating a total delay of the delay line interpolator (13,19) of the time-to-digital converter (2) to equal a cycle time (16) of the reference clock frequency (S); and measuring cycle time of a modulated input signal (1) the step of measuring including the steps of:
sensing a rising edge (20) of the signal (1) upon receipt of the signal by the delay line interpolator (13,19);
storing a state of the delay line interpolator (13,19) in response to an end of a time interval of propagation of the signal through the delay line interpolator (13,19);
coding a length of the time interval based on the sensed rising edge (20) and stored state; and
obtaining an instantaneous frequency based on the coded length of the time interval whereby the frequency or phase modulated signal (1) has been sensed.

2. A method as in claim 1, characterized in that the counter (12) coarsely quantizes the time interval (9).

3. A method as in claim 1, characterized in that it further comprises the step of evaluating fractions (10, 11) of the reference clock cycle time with aid of the delay line interpolator (13,19).

4. A method as in claim 1, characterized in that it further comprises the step of using fast logic gates as delay elements (28) of the delay line interpolator (13,19) in order to achieve a single measurement resolution of less than one nanosecond.

5. A method as in claim 2. characterized in that it further comprises the step of providing a further delay line interpolator (14) to allow the coarsely done quantizing to be done more accurately than would result without the further delay line interpolator.

6. A method as in claim 1. characterized in that it further comprises the step of demodulating the modulated signal (1) after the cycle time is measured.

7. A method as in claim 6, characterized in that it further comprises the step of filtering and limiting the demodulated signal.

8. Circuitry for demodulating a frequency or phase modulated signal (1) comprising a time-to-digital converter (2) which includes a frequency counter (12) for counting cycles of a reference clock (15) frequency and at least one delay line interpolator (13,19), characterized in that it further includes:
means (24) for allowing calibration of a total delay of the delay line interpolator (13,19) to equal a cycle time (16) of the reference clock frequency; and
means (2) for measuring cycle time of a modulated input signal (1), said measuring means comprising:
sensing means for sensing a rising edge (20) of the signal upon receipt of the signal by the delay line interpolator (13,19);
storing means (21) for storing a state of the delay line interpolator (13,19) in response to an end of a time interval of propagation of the signal through the delay line interpolator (13,19);
coding means (22) for coding a length of the time interval based on the sensed rising edge (20) and stored state; and
means for obtaining an instantaneous frequency based on the coded length of the time interval whereby the frequency or phase modulated signal (1) has been sensed.

9. Circuitry as in claim 8, characterized in that the frequency counter (12) coarsely quantizes the time interval (9).

10. Circuitry as in claim 8, characterized in that it further comprises means for evaluating fractions (10,11) of the reference clock cycle time with aid of the delay line interpolator (13,19).

11. Circuitry as in claim 8, characterized in that it further comprises fast logic gates as delay elements (28) of the delay line interpolator (13,19) for achieving single measurement resolution of less than one nanosecond.

12. Circuitry as in claim 9, characterized in that it comprises a further delay line interpolator (14) for enabling the coarsely done quantizing to be done more accurately than may occur without the further delay line interpolator.

13. Circuitry as in aim 8, characterized in that it further comprises means (4) for demodulating the modulated signal after the cycle time is measured.

14. Circuitry as in claim 13, characterized in that it further comprises means (6) for filtering and limiting the demodulated signal.

## Patentansprüche

1. Verfahren zum Demodulieren eines frequenz- oder phasenmodulierten Signals (1) unter Verwendung eines Zeit-Digital-Umsetzers (2) mit einem Zähler (12) zum Zählen von Zyklen einer Bezugstaktfrequenz des Zeit-Digital-Umsetzers, und mit einem Verzögerungsleitungs-Interpolator (13, 19), **dadurch gekennzeichnet, daß** es folgende Schritte umfaßt:
- Kalibrieren der Gesamtverzögerung des Verzögerungsleitungs-Interpolators (13, 19) des Zeit-Digital-Umsetzers (2), so, daß Übereinstimmung mit der Zykluszeit (16) der Bezugstaktfrequenz (S) besteht; und
- Messen der Zykluszeit eines modulierten Eingangssignals (1), wobei dieser Meßschritt folgende Schritte umfaßt:
-- Messen der ansteigenden Flanke (20) des Signals (1) beim Empfang desselben mittels des Verzögerungsleitungs-Interpolators (13, 19);
-- Einspeichern des Zustands des Verzögerungsleitungs-Interpolators (13, 19) beim Zeitintervallende der Ausbreitung des Signals durch den Verzögerungsleitungs-Interpolator (13, 19) hindurch;
-- Codieren der Länge des Zeitintervalls auf Grundlage der erfaßten ansteigenden Flanke (20) und des abgespeicherten Zustands; und
-- Erhalten der Momentanfrequenz auf Grundlage der codierten Länge des Zeitintervalls, wodurch das frequenz- oder phasenmodulierte Signal (1) erfaßt ist.

2. Verfahren nach Anspruch 1, **dadurch gekennzeichnet, daß** der Zähler (12) das Zeitintervall (9) grob quantisiert.

3. Verfahren nach Anspruch 1, **dadurch gekennzeichnet, daß** es ferner den Schritt des Auswertens von Bruchteilen (10, 11) der Bezugstakt-Zykluszeit mit Hilfe des Verzögerungsleitungs-Interpolators (13, 19) beinhaltet.

4. Verfahren nach Anspruch 1, **dadurch gekennzeichnet, daß** es ferner den Schritt des Verwendens schneller Logikgatter als Verzögerungselemente (28) des Verzögerungsleitungs-Interpolators (13, 19) umfaßt, um eine Einzelmeßauflösung von weniger als einer Nanosekunde zu erzielen.

5. Verfahren nach Anspruch 2, **dadurch gekennzeichnet, daß** es ferner den Schritt des Bereitstellens eines weiteren Verzögerungsleitungs-Interpolators (14) umfaßt, um es zu ermöglichen, daß das grob erfolgte Quantisieren genauer erfolgen kann, als es ohne den weiteren Verzögerungsleitungs-Interpolator möglich wäre.

6. Verfahren nach Anspruch 1, **dadurch gekennzeichnet, daß** es ferner den Schritt des Demodulierens des modulierten Signals (1) nach dem Messen der Zykluszeit umfaßt.

7. Verfahren nach Anspruch 6, **dadurch gekennzeichnet, daß** es weiter den Schritt des Filterns und Begrenzens des demodulierten Signals umfaßt.

8. Schaltung zum Demodulieren eines frequenz- oder phasenmodulierten Signals (1) mit einem Zeit-Digital-Umsetzer (2), der einen Frequenzzähler (12) zum Zählen von Zyklen der Frequenz eines Bezugstakts (15) und mindestens einen Verzögerungsleitungs-Interpolator (13, 19) enthält, **dadurch gekennzeichnet, daß** sie weiter folgendes beinhaltet:
- eine Einrichtung (24), die eine Kalibrierung der Gesamtverzögerung des Verzögerungsleitungs-Interpolators (13, 19) in solcher weise ermöglicht, daß sie der Zykluszeit (16) der Bezugstaktfrequenz gleich ist; und
- eine Einrichtung (2) zum Messen der Zykluszeit des modulierten Eingangssignals (1), mit
-- einer Erfassungseinrichtung zum Erfassen der steigenden Flanke (20) des Signals bei Empfang des Signals mittels des Verzögerungsleitungs-Interpolators (13, 19);
-- einer Speichereinrichtung (21) zum Einspeichern des Zustands des Verzögerungsleitungs-Interpolators (13, 19) beim Zeitintervallende der Ausbreitung des Signals durch den Verzögerungsleitungs-Interpolator (13, 19);
-- einer Codiereinrichtung (22) zum Codieren der Länge des Zeitintervalls auf Grundlage der erfaßten steigenden Flanke (20) und des abgespeicherten Zustands; und
-- einer Einrichtung zum Erhalten der Momentanfrequenz auf Grundlage der codierten Länge des Zeitintervalls, wodurch das frequenz- oder phasenmodulierte Signal (1) erfaßt wurde.

9. Schaltung nach Anspruch 8, **dadurch gekennzeichnet, daß** der Frequenzzähler (12) das Zeitintervall (9) grob quantisiert.

10. Schaltung nach Anspruch 8, **dadurch gekennzeichnet, daß** sie ferner eine Einrichtung zum Auswerten von Bruchteilen (10, 11) der Bezugstakt-Zykluszeit mit Hilfe des Verzögerungsleitungs-Interpolators (13, 19) umfaßt.

11. Schaltung nach Anspruch 8, **dadurch gekennzeichnet, daß** sie ferner schnelle Logikgatter als Verzögerungselemente (28) des Verzögerungsleitungs-Interpolators (13, 19) umfaßt, um eine Einzelmeßauflösung von weniger als einer Nanosekunde zu erzielen.

12. Schaltung nach Anspruch 9, **dadurch gekennzeichnet, daß** sie einen weiteren Verzögerungsleitungs-Interpolator (14) umfaßt, um es zu ermöglichen, daß die grob erfolgte Quantisierung genauer erfolgen kann, als dies ohne den weiteren Verzögerungsleitungs-Interpolator möglich wäre.

13. Schaltung nach Anspruch 8, **dadurch gekennzeichnet, daß** sie ferner eine Einrichtung (4) zum Demodulieren des modulierten Signals nach dem Messen der Zykluszeit umfaßt.

14. Schaltung nach Anspruch 13, **dadurch gekennzeichnet, daß** sie ferner eine Einrichtung (6) zum Filtern und Begrenzen des demodulierten Signals umfaßt.

## Revendications

1. Procédé pour démoduler un signal modulé en fréquence ou en phase (1) utilisant un convertisseur temps/numérique (2) comportant un compteur (12) pour compter les cycles d'une fréquence d'horloge de référence du convertisseur temps/numérique et un interpolateur à lignes à retard (13, 19) caractérisé en ce qu'il comprend les étapes consistant à :
étalonner un retard total de interpolateur à lignes à retard (13, 19) du convertisseur temps/numérique (2) pour qu'il soit égal à un temps de cycle (16) de la fréquence d'horloge de référence (S) ; et mesurer le temps de cycle du signal d'entrée modulé (1), l'étape de la mesure comportant les étapes consistant à :
détecter un front montant (20) du signal (1) sur réception du signal par l'interpolateur à lignes à retard (13, 19) ;
mémoriser un état de l'interpolateur à lignes à retard (13, 19) en réponse à la fin d'un intervalle de temps de propagation du signal dans l'interpolateur à lignes à retard (13, 19)
coder la durée de l'intervalle de temps basé sur le front montant détecté (20) et l'état mémorisé ; et
obtenir une fréquence instantanée basée sur la durée codée de l'intervalle de temps d'où il résulte que le signal modulé en fréquence ou en phase (1) est détecté.

2. Procédé selon la revendication 1, caractérisé en ce que le compteur (12) quantifie grossièrement l'intervalle de temps (9).

3. Procédé selon la revendication 1, caractérisé en ce qu'il comprend de plus l'étape consistant à évaluer des fractions (10, 11) du temps de cycle de l'horloge de référence à l'aide de l'interpolateur à lignes de retard (13, 19).

4. Procédé selon la revendication 1, caractérisé en ce qu'il comprend de plus l'étape consistant à utiliser des portes logiques rapides en tant qu'éléments à retard (28) de l'interpolateur à lignes à retard (13, 19) afin d'obtenir une résolution à une seule mesure qui est inférieure à une nanoseconde.

5. Procédé selon la revendication 2, caractérisé en ce qu'il comprend de plus l'étape consistant à prévoir un autre interpolateur à lignes à retard (14) pour permettre que la quantification faite grossièrement soit faite plus précisément que celle que l'on pourrait obtenir sans l'autre interpolateur à lignes à retard.

6. Procédé selon la revendication 1, caractérisé en ce qu'il comprend de plus l'étape consistant à démoduler le signal modulé (1) après que le temps de cycle soit mesuré.

7. Procédé selon la revendication 6, caractérisé en ce qu'il comprend de plus l'étape consistant à filtrer et limiter le signal démodulé.

8. Circuits pour démoduler un signal modulé en fréquence ou en phase (1) comprenant un convertisseur temps/numérique (2) qui comporte un compteur de fréquence (12) pour compter les cycles d'une fréquence d'horloge de référence (15) et au moins un interpolateur à lignes à retard (13, 19), caractérisé en ce qu'il comporte de plus :
un moyen (24) pour permettre l'étalonnage du retard total de interpolateur à lignes à retard (13,19) pour que celui-ci soit égal à un temps de cycle (16) de la fréquence d'horloge de référence ; et
un moyen (2) pour mesurer le temps de cycle d'un signal d'entrée modulé (1),ledit moyen de mesure comprenant :
un moyen de détection pour détecter un front montant (20) du signal sur réception du signal par l'interpolateur à lignes à retard (13, 19) ;
un moyen de mémorisation (21) pour mémoriser un état de l'interpolateur à lignes à retard (13, 19) en réponse à la fin de la propagation de l'intervalle de temps du signal dans l'interpolateur à lignes à retard (13, 19) ;
un moyen de codage (22) pour coder la durée de l'intervalle de temps basé sur le front montant détecté (20) et l'état mémorisé ; et
un moyen pour obtenir une fréquence instantanée basée sur la durée codée de l'intervalle de temps d'où il résulte que le signal modulé en fréquence ou en phase (1) est détecté.

9. Circuits selon la revendication 8, caractérisé en ce que le compteur de fréquence (12) quantifie grossièrement l'intervalle de temps (9).

10. Circuits selon la revendication 8, caractérisé en ce qu'il comprend de plus un moyen pour évaluer les fractions (10, 11) du temps de cycle de l'horloge de référence à l'aide de l'interpolateur à lignes à retard (13, 19).

11. Circuits selon la revendication 8, caractérisé en ce qu'il comprend de plus des portes logiques rapides comme éléments de retard (28) de l'interpolateur à lignes à retard (13, 19) pour obtenir une résolution en une seule mesure inférieure à une nanoseconde.

12. Circuits selon la revendication 9, caractérisé en ce qu'il comprend un autre interpolateur à lignes à retard (14) pour permettre la quantification faite grossièrement d'être faite plus précisément que celle qu'on pourrait obtenir sans l'autre interpolateur à lignes à retard.

13. Circuits selon la revendication 8, caractérisé en ce qu'il comprend de plus un moyen (4) pour démoduler le signal modulé après que le temps de cycle soit mesuré.

14. Circuits selon la revendication 13, caractérisé en ce qu'il comprend de plus un moyen (6) pour filtrer et limiter le signal démodulé.
